# EUROPÄISCHE PATENTSCHRIFT

(11) **EP 0 301 533 B1**
(45) Veröffentlichungstag und Bekanntmachung des Hinweises auf die Patenterteilung: **10.03.1993**
(21) Anmeldenummer: 88112201.4
(22) Anmeldetag: 28.07.1988
(51) Int. Cl.: H01H 85/04, H01H 69/02

(54) **Elektrische Sicherung und Verfahren zu ihrer Herstellung**
Electric fuse and method for its manufacture
Fusible électrique et méthode de sa fabrication

(30) Priorität: 30.07.1987 DE 3725280; 23.12.1987 DE 3743857
(43) Veröffentlichungstag der Anmeldung: 01.02.1989
(73) Patentinhaber: Wickmann-Werke GmbH, D-58453 Witten (DE)
(72) Erfinder: Poerschke, Karl, Dr.-Ing., D-4322 Sprockhövel 2 (DE); Stärk, Klaus, Dipl.-Phys., D-5810 Witten (DE); Fröchte, Bernd, Dipl.-Ing., D-4690 Herne 1 (DE)
(74) Vertreter: Patentanwälte Wenzel & Kalkoff

(56) Entgegenhaltungen:
- EP-A- 0 030 157
- DE-A- 2 220 370
- FR-A- 2 528 617
- US-A- 4 680 568

## Beschreibung

Die Erfindung betrifft eine elektrische Sicherung mit zwei gegebenenfalls plattierten Kontaktflächen als Zuleitungen und einem auf die Kontaktflächen aufgeschweißten oder aufgebondeten Schmelzdraht sowie ein Herstellungsverfahren. Eine solche Sicherung ist aus FR-A-2 528 617 bekannt.

Das Aufschweißen bzw. Aufbonden von Schmelzleitern auf Kontaktflächen ist insbesondere bei Sicherungen besonders zu bevorzugen, die in sogenannter SMD-Technik zum Bestücken einer Leiterplatte oder dergleichen verwendetet werden sollen. Dabei wird der Grundkörper der Sicherung auf die Platine aufgeklebt und anschließend in einem Schwallbad Lot zur Verbindung der auf der Platine aufstehenden Kontaktflächen zugegeben oder eine an dieser Stelle vorher aufgebrachten Lötpaste durch eine Erwärmung zum Schmelzen gebracht. Im Ergebnis wird die elektrische Sicherung annähernd auf Weichlottemperatur gebracht, so daß Weichlötungen zum Befestigen des Schmelzleiters unterbrochen oder in sonstiger Weise verändert werden können. Insbesondere ist eine Legierungsbildung durch Diffusion oftmals zu beobachten, wodurch die Charakteristik der Sicherung möglicherweise verändert wird, zumindest jedoch eine Alterung einsetzt.

Wenn die Verbindung zwischen dem Schmelzleiter und den Kontaktflächen durch Schweißen oder Bonden hergestellt wird, werden diese nachteiligen Erscheinungen beim Anlöten der Sicherung auf eine Platine vermieden. Allerdings ist das Aufschweißen bzw. Aufbonden von Schmelzdrähten auch mit Nachteilen verbunden. Für beide Fügetechniken ist ein gewisser Druck auf den Schmelzleiter und die jeweilige Kontaktfläche erforderlich, wobei der Schmelzleiter und gegebenenfalls das Grundmaterial der Kontaktflächen bzw. eine dort aufgebrachte Plattierung mehr oder weniger stark verformt werden. Eine derartige Verformung kann zu Rissen und insbesondere zu Mikrorissen führen, die sich im Laufe späterer Beanspruchungen ausbreiten können. Mit jeder Beanspruchung der elektrischen Sicherung ist nämlich eine Dehnung des Schmelzleiters und eine abschließende Schrumpfung verbunden, so daß die Schweiß- oder Bondstelle bei jedem Einschaltzyklus eines Gerätes, für das die Sicherung eingesetzt ist, mechanisch beansprucht wird. Insbesondere Mikrorisse können sehr schlecht im Anfangszustand entdeckt werden, da sie zunächst volleitend sind, also über die Kontrolle der elektrischen Werte ihr Auffinden nicht möglich ist. Selbst eine Betrachtung in einem optischen Mikroskop ist keine Garantie dafür, daß derartige Beschädigungen erkannt werden.

Es ist Aufgabe der Erfindung, eine Sicherung der eingangs genannten Art sowie ein Verfahren zu ihrer Herstellung vorzuschlagen, bei deren Verwirklichung trotz eines Schweiß- oder Bondvorganges ein zuverlässiger Kontakt des Schmelzleiters an den Kontaktflächen hergestellt wird, der auch durch mechanische Beanspruchungen in Folge der Einschaltzyklen seine Ausgangsqualität behält, so daß die entsprechend gefertigte Sicherung nicht vom Ausfall einer Beschädigung im Verbindungsbereich zwischen dem Schmelzleiter und den Kontaktflächen bedroht ist.

Zur Lösung dieser Aufgabe schlägt die Erfindung bezüglich einer Sicherung vor, daß der Schmelzdraht im Schweiß- oder Bondbereich über die eigentliche Kontaktzone hinaus ummantelt ist. Bezüglich des Verfahrens schlägt die Erfindung vor, daß nach dem Anschweißen bzw. Bonden des auf seiner gesamten Länge ummantelten Schmelzleiters auf die Kontaktfläche der Schweiß- oder Bondbereich mit einer ätzfesten Schutzabdeckung versehen wird und anschließend der Mantel in den Bereichen außerhalb der Schutzabdeckung weggeätzt wird.

Die beim Schweißen bzw. Bonden unvermeidbare Verformung des Schmelzleiters tritt selbstverständlich auch bei einem Schmelzleiter auf, der aus einem Kerndraht und aus einer Ummantelung besteht. Wenn jedoch, wie erfindungsgemäß vorgesehen, die Ummantelung über den eigentlichen Schweiß- oder Bondbereich hinaus vorhanden ist, ergeben sich trotz einer Verquetschung des gesamten Schmelzleiters im eigentlichen Verbindungsbereich daneben ausreichende Leitungsquerschnitte, die dafür sorgen, daß sich z.B. ein Mikroriß im eigentlichen Verbindungsbereich nicht auswirkt, da über die Ummantelung ein ausreichend großflächiger Strompfad vorhanden ist, der alle in Frage kommenden elektrischen Ströme ohne Ausfallerscheinungen bis in den ummantelten Bereich unmittelbar neben der eigentlichen Fügestelle leitet. Außerhalb dieses Bereiches hört die Ummantelung auf, so daß von dieser Stelle bis zu der Fügestelle des anderen Schmelzdrahtendes lediglich der Kerndraht existiert. Dieser wird zuverlässig und unter allen Bedingungen ausreichend mit der jeweils zugehörigen Kontaktfläche elektrisch verbunden.

Das Ummanteln von Schmelzleitern ist für sich gesehen nicht neu (siehe z.B. DE-A-2 220 370). Insbesondere zur Beeinflussung der Charakteristik werden z.B. Silberkerndrähte mit Zinnumhüllungen oder dergleichen versehen, um über eine Schmelzpunktabsenkung infolge einer Legierungsbildung zwischen diesen beiden Metallen ein verändertes Abschalten herbeizuführen. Bei der Erfindung wird jedoch die Ummantelung nicht für die Ausbildung der Charakteristik eingesetzt, sondern einzig und allein zur Verbesserung der Kontaktierung zwischen dem Kerndraht des Schmelzleiters und den zugeordneten Kontaktflächen. Im fertigen Zustand ist nämlich erfindungsgemäß die Ummantelung im eigentlichen Arbeitsbereich der Sicherung entfernt, so daß lediglich der Kerndraht zur Beeinflussung der Charakteristik zur Verfügung steht. Neben den geschilderten Vorteilen des garantierten, zuverlässigen Kontaktüberganges jeweils von der Kontaktfläche zu dem Schmelzleiter und vom Schmelzleiter zu der weiteren Kontaktfläche ist noch ein weiterer besonderer Vorteil dieser Lösung zu erwähnen:

Da das Material der Ummantelung relativ frei gewählt werden kann - es ist auf das Schmelzverhalten oder die Legierungsbildung mit dem Kerndraht kein Augenmerk zu richten - kommt eine Auswahl nach der Schweißbarkeit bzw. nach der Befestigungsmöglichkeit durch Bonden in Frage; insbesondere kann eine Abstimmung zu dem Grundmaterial der Kontaktfläche vorgenommen werden oder zu einer Plattierung, die zu diesem Zweck auf das Grundmaterial der Kontaktflächen aufgebracht worden ist. Da das Bonden eine Art Kaltpreßschweißen mit kleinen Reibwegen ist, können für dieses Verfahren geeignete Materialien aufgebracht werden. Sehr gut eignet sich z.B. Silber, das als Ummantelung eines Golddrahtes eingesetzt werden kann, wobei das spätere Entfernen durch Salpetersäure vorgenommen wird.

Insbesondere ist jedoch das Augenmerk auf preiswertere Ummantelungen gerichtet, z.B. auf Ummantelungen aus Aluminiumlegierungen. Hier ist in erster Linie eine Aluminium-Siliziumlegierung mit einem Gehalt von 1% Silizium zu erwähnen, die sehr gut zum Bonden geeignet ist. Außerdem verfügt sie über eine ausreichende Korrosionsbeständigkeit infolge der sich selbsttätig ausbildenden Oxidschicht. Aluminium und seine Legierung können in Natronlauge sehr leicht entfernt werden, die andererseits Kupfer oder Silber nicht angreift.

Wenn bei dem Ätzvorgang auch die Plattierung außerhalb der Schutzabdeckung z.B. in Form eines Harzes weggeätzt wird, so ist dieser Vorgang ohne Bedeutung. Infolge der Schutzabdeckung durch das Harz vor dem Aufbringen des Ätzmittels bleibt eine genügend große "Insel" unveränderter Materialkonfiguration erhalten, die in jedem Fall ausreicht, um stabile und zuverlässige Leitbedingungen aufrechtzuerhalten. Dabei genügen Flächen von 1 bis 3 mm².

Rein theoretisch kann die Schutzabdeckung beispielsweise in Form eines Harzes nach dem Ätzvorgang entfernt werden. Da es jedoch die Funktion der Sicherung in der Regel nicht beeinträchtigt, kann es ohne weiteres im Bereich der Verbindung zwischen dem Schmelzdraht und den Kontaktflächen verbleiben; im Gegenteil verhindert es starke Deformationen im Bereich der Fügestellen, so daß der Verbleib sogar noch nützlich ist.

Die heute gebräuchlichen Geräte für das Aufbonden von Schmelzleitern auf Kontaktflächen sind einstellungsempfindlich, was die Dicke des zu verarbeitenden Schmelzdrahtes betrifft Bei Abweichungen von z.B. mehr als 10 µm in der Dicke eines zu verarbeitenden Drahtes muß eine entsprechende Vorrichtung neu eingestellt, also umgerüstet werden. Hier bietet die Erfindung erhebliche Vorteile: Da es unter elektrischen Gesichtspunkten auf die Ummantelung und damit auf ihre Dicke nicht ankommt, sondern diese ausschließlich unter Gesichtspunkten der einfachen Verbindung ausgewählt wird, kann für die unterschiedlichsten Sicherungen und damit für Kerndrähte unterschiedlicher Dicke jeweils eine gleichbleibende Dicke der Ummantelung gewählt werden. Im Ergebnis kann die Vorrichtung zum Bonden, ohne verstellt werden zu müssen, für alle Sicherungstypen, die nacheinander gefertigt werden, weiterarbeiten, selbst wenn z.B. die Dicke der Ummantelung zwischen dem Faktor 10 und dem Faktor 0,05 bezogen auf die Dicke des Kerndrahtes schwankt.

Es wurde eingangs bereits erwähnt, daß gebondete oder geschweißte Schmelzdrähte in Verbindung mit Sicherungen von Bedeutung sind, die zur Bestückung einer Leiterplatte in SMD-Technik vorgesehen sind. Der Grund für die Bevorzugung einer gebondeten oder geschweißten Verbindung liegt in der Notwendigkeit,bei dieser Befestigungstechnik das entsprechende elektronische oder elektrische Bauteil auf Weichlottemperatur erwärmen zu müssen. Eine weitere Bedingung ist die Bereitstellung von unter dem Bauteil liegenden oder an den Seitenkanten liegenden Anlötflächen, die entweder für das sogenannte Reflow-Verfahren unter Verwendung von Lötpasten oder für eine Schwallbadlötung vorgesehen sind. Zur Vervolkommnung einer elektrischen Sicherung gemäß der Erfindung wird in Weiterbildung vorgeschlagen, daß die Kontaktflächen auf einem Substrat, insbesondere einem Keramiksubstrat aufgebracht sind, daß auf der den Kontaktflächen abgewandten Seite des Substrates elektrisch leitende Anlötflächen angebracht sind, und daß zwischen einer Kontaktfläche und der zugeordneten Anlötfläche eine Durchkontaktierung vorgesehen ist. Eine derartige Sicherung eignet sich insbesondere für das Reflow-Verfahren.

Statt der Anlötfläche mit Durchkontaktierung kann auch jeweils eine Kantenmetallisierung vorhanden sein, die dann zu der jeweiligen Kontaktfläche eine elektrisch leitende Verbindung haben muß. Derartige Kantenmetallisierungen werden als Pasten aufgetragen und anschließend bei 500° bis 800° C eingebrannt. Je nach Art der Aufbringung der Kontaktflächen kann die Kantenmetallisierung zusammen mit den Kontaktflächen aufgebracht werden. Dazu wird bei der Massenherstellung entweder ein Substratstreifen in der Breite der späteren Sicherungslänge beidseitig mit einer Kantenmetallisierung und mit zwei sich gegenüberliegenden Kontaktflächen versehen, der dann nach der Komplettierung in einzelne Sicherungen aufgeteilt wird, oder bei flächiger Anordnung von Sicherungssubstraten im Nutzen wird die Nahtstelle zwischen zwei Einzelsicherungen mit einem Loch oder mit einem Langloch versehen, das die Kantenmetallisierung nach Art einer Durchkontaktierung erhält. Nach dem Auftrennen eines Nutzens in einzelne Sicherungen bzw. Sicherungssubstrate steht im Bereich der Löcher eine Kantenmetallisierung zur Verfügung, die für eine Schwallbadlötung vollkommen ausreicht. Die Anordnung von Löchern oder Langlöchern im Bereich der Trennlinie zwischen zwei Einzelsicherungen eines Nutzens bringt den Vorteil mit sich, daß an dieser Stelle eine Sollbruchstelle entsteht, die jeweils das Aufteilen in Einzelsicherungen an dieser Stelle erleichtert.

Besonders geeignet als Substrat für eine Sicherung gemäß der Erfindung ist ein Keramikmaterial, das trotz feiner Struktur eine gewisse Rauhigkeit der Oberfläche aufweist. Es hat sich überraschend herausgestellt, daß ein derartiges Substrat ein hervorragender Haftgrund ist für eine thermisch aufgeschweißte Kunststoffhaube, die zum Schutz des Schmelzleiters aufgebracht werden kann. Es eignen sich dazu thermoplastische Kunststoffe, die den kurzen Wärmestoß beim Reflow-Verfahren oder bei einer Schwallbadlötung ohne Schaden überstehen. Derartige Kunststoffgehäuse sind in üblicher Weise mit V-förmigen oder halbkreisförmigen Anschweißrippen versehen, die unter Wärmeeinwirkung gegen das Substrat gedrückt werden, stark verformt werden und eine allseits gasdichte Abdichtung bilden.

Bei der Fertigung im Nutzen kann selbstverständlich das Aufbringen der Kunststoffhauben ebenfalls im Nutzen erfolgen, wobei die Trennung der einzelnen Hauben später zusammen mit der Aufteilung in die Einzelsicherungen erfolgt. Dazu sind die Kunststoffhauben mit kleinen Stegen oder entlang von Sollbruchstellen miteinander verbunden. Im übrigen beansprucht die Erfindung auch Schutz für entsprechende Herstellungsverfahren mit seinen Varianten, und in diesem Zusammenhang wird auf die Ansprüche 12 bis 16 verwiesen.

Nachfolgend werden Ausführungsbeispiele der Erfindung, die in der Zeichnung dargestellt sind, näher erläutert; in der Zeichnung zeigen:
- Fig. 1: eine Querschnittsansicht durch eine Sicherung gemäß der Erfindung für eine SMD-Bestückung,
- Fig. 2: eine Querschnittsansicht im Ausschnitt des Schmelzleiterbereichs der Sicherung gemäß der Figur 1 oder einer anderen Sicherung,
- Fig. 3: eine Querschnittsansicht durch die eigentliche Fügestelle zwischen einem Schmelzdraht und einer Kontaktfläche,
- Fig. 4: eine Querschnittsansicht gemäß der Figur 1 eines weiteren Ausführungsbeispiels der Erfindung,
- Fig. 5: eine Querschnittsansicht gemäß der Figur 1 eines dritten Ausführungsbeispiels der Erfindung und
- Fig. 6: eine Draufsicht auf einen Nutzen von Einzelsubstraten vor der Aufteilung.

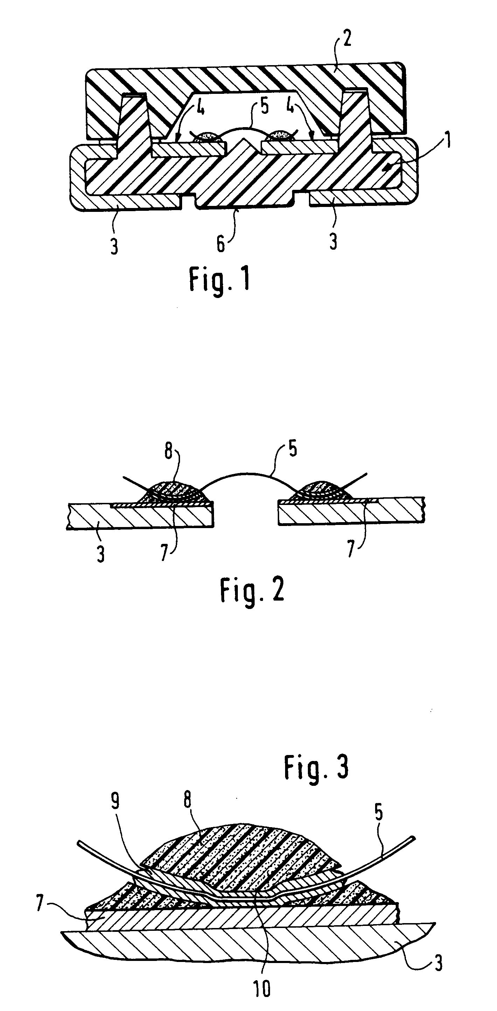

In der Figur 1 ist eine elektrische Sicherung gemäß der Erfindung zu erkennen, die aus Gründen der besseren Deutlichkeit wesentlich größer als in Wirklichkeit wiedergegeben ist. Sie besteht aus einem Grundkörper 1 aus Kunststoff, über den mit Hilfe von entsprechenden Stiften nach Fertigstellung der Sicherung ein Deckel 2 gestülpt ist. Zu beiden Seiten des Grundkörpers 1 sind jeweils Kontakte 3 U-förmig um den Grundkörper herumgebogen, die unterhalb des Deckels 2 sich gegenüberliegende Kontaktflächen 4 bilden. Zwischen diesen Kontaktflächen ist ein Schmelzleiter 5 gespannt, der erfindungsgemäß befestigt ist. Für die Vorbefestigung der Sicherung auf einer Platine oder einem Substrat befindet sich auf der Außenseite des Grundkörpers 1 zwischen den Kontakten 3 eine Klebefläche 6.

In der Figur 2 sind nähere Einzelheiten der Verbindung des Schmelzleiters 5 an den Kontaktflächen 4 zu erkennen. Im Bereich der Fügestellen ist eine Plattierung 7 vorgesehen, die auf das Material einer Ummantelung 9 (Fig. 3) abgestimmt ist, insbesondere aus demselben Material wie die Ummantelung 9 bestehen kann. Ein Ausschnitt der einen Verbindungsstelle ist wiederum mit deutlicher Vergrößerung in der Figur 3 wiedergegeben, die nachfolgend genauer beschrieben wird.

Zunächst werden die beiden Kontakte 3, die mit Hilfe von nicht dargestellten Fremdmitteln oder durch eine später zu entfernende Brücke in ihrer späteren Funktionslage gehalten werden, mit einer Plattierung 7 beispielsweise aus Aluminium versehen. Anschließend wird der Schmelzleiter 5 durch Schweißen oder Bonden aufgebracht, wobei im vorliegenden Fall die Verbindung durch Bonden hergestellt worden ist. Dabei wird der ummantelte Schmelzleiter im Bereich der Verbindungsstellen leicht gequetscht, so daß jungfräuliches Material aus der Ummantelung und aus der Plattierung zueinanderfinden und sich nach Art einer Kaltpreßschweißung verbinden. Der verformte Bereich 10 ist deutlich in der Figur 3 zu erkennen.

Es sei davon ausgegangen, daß der Kerndraht des Schmelzleiters aus Silber und die Ummantelung 9 aus Aluminium besteht. Es ist dann im verformten Bereich 10 eine Verbindung zwischen dem Aluminium der Ummantelung und der Plattierung 7 zustande gekommen. Die ebenfalls starke Verformung des Kerndrahtes innerhalb des verformten Bereiches 10 ist ebenfalls deutlich zu erkennen; sie ist jedoch ohne negative Wirkung.

Nach dem Bonden des Schmelzdrahtes 5 auf die Plattierung wird auf die Verbindungsstelle ein Tropfen Epoxyharz 8, Silikon oder Lack aufgegeben, der gegenüber Natronlauge resistent ist. Nach der Fertigstellung der Verbindung am anderen Ende des Schmelzdrahtes 5 wird die so vorgefertigte Sicherung in ein Ätzbad aus Natronlauge gegeben. Die Ätzwirkung hat zur Folge, daß das Aluminium sowohl der Ummantelung 9 als auch der Plattierung 7 außerhalb der Abdeckbereiche entfernt wird. Die Unterätzungen sind in der Figur 3 deutlich zu erkennen.

Nachdem über Versuche festgestellt worden ist, wann die komplette Wegätzung der Ummantelung 9 außerhalb des Abdeckbereiches durch das Abdeckmaterial 8 abgeschlossen ist - eine noch nicht ganz entfernte Plattierung 7 ist unerheblich - wird mit einem Sicherheitszuschlag von beispielsweise 10% eine bestimmte Ätzdauer festgelegt. Danach wird die Sicherung gewaschen, und die beiden Kontakte 3 werden auf den Grundkörper 1 aufgebracht, wobei bis dahin vorhandene Brücken zwischen beiden Kontakten endgültig entfernt werden. Schließlich wird ein Deckel 2 (Figur 1) aufgesetzt, und damit ist die Sicherung gebrauchsfertig.

Aus der Figur 3 ist deutlich zu erkennen, daß im Bereich der Verbindung zwischen der Ummantelung 9 und der Plattierung 7 ein sehr großer Flächenbereich zur Verfügung steht, um die elektrische Leitung zwischen dem Kontakt 3 und dem Schmelzleiter 5 zu bewirken. Die große Fläche setzt sich in der Ummantelung bis annähernd an den Rand der Schutzabdeckung fort, an der ein weicher Übergang auf den nun nackten Kerndraht vorhanden ist. Selbst wenn also im verformten Bereich 10 oder unmittelbar daneben Risse oder Mikrorisse aufgetreten sind, bleiben sie ohne Auswirkung. Selbst wenn nämlich an dieser Stelle eine Durchtrennung des Kerndrahtes vorhanden wäre, würde die Ummantelung 9 die elektrische Leitung bis zum Übergang auf den nackten Kerndraht besorgen, so daß keine Gefahr eines Ausfalls der Sicherung durch eine Beschädigung im Verbindungsbereich zu befürchten ist. Falls durch die erläuterten Belastungen durch Ein- und Ausschalten der Sicherung oder durch Alterung sich zusätzlich Risse bilden oder Mikrorisse wachsen,bleiben sie auf die Ummantelung beschränkt, da am Übergang zum Kerndraht eine andere Kristallstruktur auftritt, die eine Sperre für das Weiterwachsen von Mikrorissen bildet.

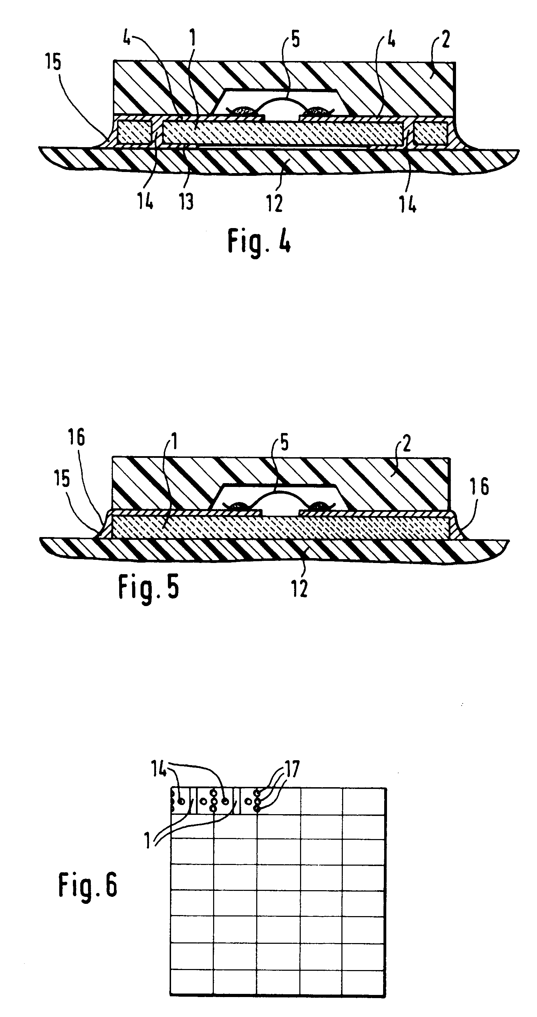

In der Figur 4 ist ein weiteres Ausführungsbeispiel der Erfindung für eine Sicherung wiedergegeben, die für die Bestückung in SMD-Technik vorgesehen ist. Wie in Verbindung mit dem vorangehend beschriebenen Ausführungsbeispiel bereits erläutert, ist der Grundkörper 1 mit zwei Kontaktflächen 4 versehen, zwischen denen in der erläuterten Weise der Schmelzleiter 5 das elektrische Bindeglied bildet. Unterhalb jeder Kontaktfläche 4, also auf der der Leiterplatte 12 zugewandten Seite des Grundkörpers 1 befindet sich jeweils eine Anlötfläche 13, zu der mit Hilfe einer Durchkontaktierung 14 ein elektrischer Kontakt zu den Kontaktflächen besteht. Eine derartige Sicherung eignet sich insbesondere für das Reflow-Verfahren, bei der das elektrische Bauteil in aufgetupfte oder aufgedruckte Lötpaste gelegt und anschließend zusammen mit der Leiterplatte erwärmt wird. In der Figur 4 ist überschüssiges Lot 15 seitlich des Grundkörpers 1 dargestellt.

Der Deckel 2 bzw. ein Kunststoffgehäuse ist direkt auf den aus Keramik bestehenden Grundkörper aufgesetzt und thermisch verschweißt. Es hat sich überraschend herausgestellt, daß zwischen dem Deckel 2 und dem Keramiksubstrat bei einem thermoplastischen Material eine sehr innige, gut haftende Verbindung entsteht. Selbstverständlich kann der Deckel 2 auch angeklebt werden, sofern der Kleber die Temperaturbelastung des Reflow-Lötvorganges aushält.

In der Figur 5 ist ein weiteres Ausführungsbeispiel einer Sicherung gemäß der Erfindung wiedergegeben, das sich von dem vorangehend beschriebenen insbesondere dadurch unterscheidet, daß keine Anlötflächen auf der Unterseite des als Grundkörper 1 dienenden Substrates vorhanden sind, sondern metallisierte Kanten 16. Die Unterseite des Grundkörpers 1 steht also für eine Klebung mit der darunterliegenden Leiterplatte 12 zur Verfügung, so daß dieses Ausführungsbeispiel insbesondere für ein Schwallbadlötung geeignet ist.

Die metallisierten Kanten 16 können in der unterschiedlichsten Weise hervorgebracht werden. Die übliche Art ist das Auftragen einer Paste, die dann anschließend bei ca. 500° bis 800° C eingebrannt wird. Eine besonders wirtschaftliche Fertigung ergibt sich dann, wenn ein Streifen in der Breite des Grundkörpers an beiden Seiten über seine gesamte Länge mit einer metallisierten Kante 16 versehen wird und anschließend die Schmelzdrähte für alle Einzelsicherungen des Streifens beispielsweise durch Bonden aufgebracht werden. Anschließend wird der Deckel beispielsweise durch thermisches Schweißen aufgesetzt, und der Streifen wird daraufhin zur Hervorbringung der Einzelsicherungen aufgeteilt.

Eine andere Art der Kantenmetallisierung kann mit Hilfe von Löchern 17 (Figur 6) hervorgebracht werden, wenn zum Beispiel im Nutzen gearbeitet wird und die Einzelsicherungen nicht nur übereinander sondern auch nebeneinander angeordnet sind. Zwischen jeder Einzelsicherung werden dann zum Beispiel drei Löcher 17 oder abweichend davon wird ein Langloch in der Länge der drei Löcher 17 in das Substrat, also den Grundkörper 1 eingebracht und in üblicher Weise "durchkontaktiert", obwohl auf der Unterseite des Grundkörpers 1 nicht unbedingt ein Leiter vorhanden sein muß. Mit Hilfe dieser "Durchkontaktierung" entstehen an drei Stellen bzw. über eine gewissen Bereich der Seitenkante metallisierte Abschnitte bzw. ein metallisierter Abschnitt, der als Anlötmöglichkeit insbesondere in Verbindung mit einer Schwallbadlötung vollkommen ausreicht. Dieselben Löcher 17 bzw. dasselbe Langloch dient später zur Definition einer Sollbruchstelle, wenn die Aufteilung des Nutzens in einzelne Sicherungen vorgenommen wird.

In der Figur 6 markieren die vertikalen und horizontalen Linien jeweils Sollbruchstellen bzw. spätere Trennlinien, entlang derer in annähernd jedem Verfahrensstadium die Aufteilung erfolgen kann. Besonders zweckmäßig ist die Fertigstellung jeder Einzelsicherung im Nutzen einschließlich des Aufbringens der Deckel 2, um dann erst die Aufteilung vorzunehmen. In dieser Weise kann eine Automatisierung besonders nutzbringend Verwendung finden.

In der Figur 6 ist zwischen den erkennbaren Flächen des Grundkörpers 1 und jeder Sollbruchstelle in Form der drei Löcher 17 jeweils ein weiteres Loch zu erkennen, das in Verbindung mit einer Durchkontaktierung 14 (Figur 4) genutzt werden kann. Dasselbe Substrat als Grundkörper 1 kann also zu einer Sicherung gemäß dem Ausführungsbeispiel der Fig. 4 oder gemäß dem Ausführungsbeispiel der Figur 5 herangezogen werden, wobei im letzteren Fall die Durchkontaktierung ins Leere geht bzw. nicht planmäßig für die Kontaktierung zu den Bahnen der Leiterplatte 12 eingesetzt wird. Es sei noch darauf hingewiesen, daß selbstverständlich eine metallisierte Kante 16 auch zur Durchkontaktierung einer darunterliegenden Anlötfläche 13 eingesetzt werden kann anstelle oder zusätzlich zu einer Durchkontaktierung 14. Es kommt lediglich darauf an, daß die spätere Einzelsicherung kontaktsicher auf der zugeordneten Leiterplatte 12 aufgelötet werden kann.

## Patentansprüche

1. Elektrische Sicherung mit zwei gegebenenfalls plattierten Kontaktflächen (4) als Zuleitungen und einem auf die Kontaktflächen (4) aufgeschweißten oder aufgebondeten Schmelzdraht (5), dadurch **gekennzeichnet**, daß der Schmelzdraht (5) im Schweiß- oder Bondbereich über die eigentliche Kontaktzone hinaus mit einer Ummantelung (9) versehen ist.

2. Elektrische Sicherung nach Anspruch 1, dadurch **gekennzeichnet**, daß der Schweiß- oder Bondbereich von einem Schutzharz (8) überdeckt ist.

3. Elektrische Sicherung nach Anspruch 1 oder 2, dadurch **gekennzeichnet**, daß das Material der Ummantelung (9) dem Grundmaterial bzw. der Plattierung (7) der Kontaktflächen (4) entspricht.

4. Elektrische Sicherung nach einem der Ansprüche 1 bis 3, dadurch **gekennzeichnet**, daß die Kontaktflächen (4) auf einem Substrat, insbesondere auf einem Keramiksubstrat aufgebracht sind, insbesondere aufgedruckt sind, daß auf der den Kontaktflächen (4) abgewandten Seite des Substrates elektrisch leitende Anlötflächen aufgebracht, insbesondere aufgedruckt sind, und daß zwischen einer Kontaktfläche (4) und der zugeordneten Anlötfläche eine Durchkontaktierung vorgesehen ist.

5. Elektrische Sicherung nach einem der Ansprüche 1 bis 3, dadurch **gekennzeichnet**, daß die Kontaktflächen (4) auf einem Substrat, insbesondere auf einem Keramiksubstrat, aufgebracht sind, insbesondere aufgedruckt sind, und daß zumindest bereichsweise die seitlichen Kanten des Substrates metallisiert sind.

6. Elektrische Sicherung nach Anspruch 4 oder 5, dadurch **gekennzeichnet**, daß der Schmelzdraht (5) von einer Kunststoffhaube abgedeckt ist, die direkt thermisch auf das Substrat aufgeschweißt ist.

7. Verfahren zur Herstellung einer elektrischen Sicherung nach einem der vorhergehenden Ansprüche, dadurch **gekennzeichnet**, daß nach dem Anschweißen bzw. Bonden des auf seiner gesamten Länge ummantelten Schmelzleiters (5) auf die Kontaktflächen (4) der Schweiß- oder Bondbereich mit einer ätzfesten Schutzabdeckung (8) versehen wird und anschließend die Ummantelung (9) in den Bereichen außerhalb der Schutzabdeckung weggeätzt wird.

8. Verfahren nach Anspruch 7, dadurch **gekennzeichnet**, daß als Schutzabdeckung (8) ein Epoxyharz verwendet wird.

9. Verfahren nach Anspruch 7 oder 8, dadurch **gekennzeichnet**, daß als Ummantelung (9) und Plattierung (7) Aluminium gewählt wird und als Ätzmittel Natronlauge eingesetzt wird.

10. Verfahren nach einem der Ansprüche 7 bis 9, dadurch **gekennzeichnet**, daß die Stärke des ummantelten Schmelzleiters (5) bei Kerndrähten unterschiedlicher Dicke konstant gehalten wird.

11. Verfahren nach einem der Ansprüche 7 bis 10, dadurch **gekennzeichnet**, daß die Kontaktflächen (4) auf einem Substrat aufgebracht werden, ein mehrere Kontaktflächenpaare enthaltendes Substrat mit einem endlosen Schmelzleiter (5) oder mit einer Mehrzahl von Schmelzleitern versehen wird und nach dem Ätzvorgang das Substrat in einzelne Sicherungen aufgeteilt wird.

12. Verfahren nach Anspruch 11, dadurch **gekennzeichnet**, daß an der Trennstelle zweier Einzelsubstrate mindestens ein metallisiertes Loch (17) oder ein Langloch zur Kantenmetallisierung und als Sollbruchstelle angebracht wird.

13. Verfahren nach Anspruch 11, dadurch **gekennzeichnet**, daß die Kontaktflächenpaare auf der einen Seite eines Substrates aufgebracht werden, daß auf der abgewandten Seite ein Anlötflächenpaar aufgebracht wird und die einander zugeordneten Kontakt-und Anlötflächen durchkontaktiert werden.

14. Verfahren nach Anspruch 11, dadurch **gekennzeichnet**, daß ein Substratstreifen mit nebeneinanderliegenden Kontaktflächenpaaren versehen wird, und daß die Längskanten in elektrisch leitender Verbindung mit den Kontaktflächen vor dem Aufbonden des Schmelzleiters metallisiert werden.

15. Verfahren nach einem der Ansprüche 7 bis 14, dadurch **gekennzeichnet**, daß jeder Schmelzleiter mit Hilfe einer Kunststoffhaube abgedeckt wird, die direkt auf das Substrat thermisch aufgeschweißt wird.

16. Verfahren nach einem der Ansprüche 12 bis 15, dadurch **gekennzeichnet**, daß die Kunststoffhauben in derselben Anzahl wie die Einzelsubstrate und in deren Konfiguration aneinanderhängend aufgebracht und anschließend bei der Aufteilung in die Einzelsubstrate mit aufgeteilt werden.

## Claims

1. Electrical fuse comprising two, if applicable plated, contact surfaces (4) as conductors and a fusible conductor (5) welded or bonded onto the contact surfaces, characterized in that the fusible conductor (5) is provided with a coating (9) in excess of the very contact zone within the welding or bonding area.

2. Electrical fuse according to claim 1, characterized in that the welding or bonding area is covered by a protective resin (8).

3. Electrical fuse according to claim 1 or 2, characterized in that the material of the coating (9) corresponds to the basic material respectively the plating (7) of the contact surfaces (4).

4. Electrical fuse according to one of the claims 1 to 3, characterized in that the contact surfaces (4) are applied to a substrate, especially to a ceramic substrate, especially printed, that on the side of the substrate away from the contact surfaces (4) electrical conductive soldering surface are applied, especially printed, and that there is an interlayer-connection between one contact surface (4) and the respective soldering surface.

5. Electrical fuse according to one of claims 1 to 3, characterized in that the contact surfaces (4) are applied to a substrate, especially to a ceramic substrate, especially printed, and that at least in certain areas the lateral edges of the substrate are metallised.

6. Electrical fuse according to claim 4 or 5, characterized in that the fusible conductor (5) is covered by a plastic cover which is directly thermally welded onto the substrate.

7. Method for producing an electrical fuse according to one of the preceeding claims, characterized in that after welding respectively bonding of the fusible conductor (5), being coated along its entire length, onto the contact surfaces (4), the welding or bonding area is provided with an etch-proof protective cover (8) and afterwards the coating (9) is etched away in the areas outside the protective cover.

8. Method according to claim 7, characterized in that an epoxy resin is used for the protective cover (8).

9. Method according to claim 7 or 8, characterized in that aluminium is used for the coating (9) and the plating (7) and that soda lye is used as an etching means.

10. Method according to one of claims 7 to 9, characterized in that the thickness of the coated fusible conductor (5) is kept constant with core wires of varying thickness.

11. Method according to one of claims 7 to 10, characterized in that the contact surfaces (4) are applied to a substrate, that a substrate containing several pairs of contact surfaces, is provided with an endless fusible conductor (5) or with a multitude of fusible conductors and that the substrate is divided into single fuses after etching.

12. Method according to claim 11, characterized in that there is provided at least one metallised hole (17) or an oblong hole for edge metallising and as a preset breaking point at the separation position of two single substrates.

13. Method according to claim 11, characterized in that the pairs of contact surfaces are applied to one side of the substrate, that a pair of soldering surfaces is applied to the other side and that the respective contact and soldering surfaces are contacted interlayer style.

14. Method according to claim 11, characterized in that a substrate strip is provided with pairs of contact surfaces one beside the other and that the longitudinal edges are metallised in electrical conductive connection with the contact surfaces before the bonding down of the fusible conductor.

15. Method according one of claims 7 to 14, characterized in that each fusible conductor is covered with the aid of a plastic cap which is thermally welded directly onto the substrate.

16. Method according to one of claims 12 to 15, characterized in that the plastic caps are applied as a unitary structure in the same number as the single substrates and in their configuration and afterwards, during the separation into the single substrates, are co-divided.

## Revendications

1. Fusible électrique comportant deux surfaces de contact (4) éventuellement plaquées, constituant des conducteurs d'alimentation, et un fil fusible (5) soudé ou collé aux surfaces de contact (4), caractérisé en ce que le fil fusible (5) est pourvu d'une gaine (9) dans la zone de soudage ou de collage, jusqu'au-delà de la zone de contact proprement dite.

2. Fusible électrique suivant la revendication 1, caractérisé en ce que la zone de soudage ou de collage est recouverte par une résine de protection (8).

3. Fusible électrique suivant la revendication 1 ou 2, caractérisé en ce que le matériau de la gaine (9) correspond au matériau de base ou au placage (7) des surfaces de contact (4).

4. Fusible électrique suivant l'une des revendications 1 à 3, caractérisé en ce que les surfaces de contact (4) sont déposées, notamment sont appliquées par impression, sur un substrat, notamment sur un substrat céramique, que des surfaces de brasage électriquement conductrices sont déposées, notamment appliquées par impression, sur la face du substrat tournée à l'opposé des surfaces de contact (4) et qu'il est prévu un contact traversant entre une surface de contact (4) et la surface de brasage associée.

5. Fusible électrique suivant l'une des revendications 1 à 3, caractérisé en ce que les surfaces de contact (4) sont déposées, notamment sont appliquées par impression, sur un substrat, notamment un substrat céramique, et que les bords latéraux du substrat sont métallisés au moins par endroits.

6. Fusible électrique suivant la revendication 4 ou 5, caractérisé en ce que le fil fusible (5) est recouvert par une enveloppe en matière plastique, qui est soudée thermiquement directement sur le substrat.

7. Procédé pour fabriquer un fusible électrique selon l'une des revendications précédentes, caractérisé en ce qu'après le soudage ou le collage du fil fusible (5) gainé sur toute sa longueur sur les surfaces de contact (4), on applique à la zone de soudage ou de collage un revêtement de protection (8) résistant à la corrosion et qu'ensuite on élimine par corrosion la gaine (9) dans les zones situées à l'extérieur du revêtement de protection.

8. Procédé selon la revendication 7, caractérisé en ce qu'on utilise comme revêtement de protection (8) une résine époxy.

9. Procédé selon la revendication 7 ou 8, caractérisé en ce qu'on choisit de l'aluminium pour former la gaine (9) et le placage (7) et qu'on utilise de la soude caustique comme agent corrosif.

10. Procédé selon l'une des revendications 7 à 9, caractérisé en ce qu'on maintient constante l'épaisseur du conducteur fusible gainé (5) dans le cas de fils centraux possédant des épaisseurs différentes.

11. Procédé selon l'une des revendications 7 à 10,caractériséen ce qu'on dépose les surfaces de contact (4) sur un substrat, qu'on équipe un substrat contenant plusieurs couples de surfaces de contact, d'un conducteur fusible sans fin (5) ou d'une multiplicité de conducteurs fusibles et qu'après l'opération de corrosion, on divise le substrat pour former des fusibles individuels.

12. Procédé selon la revendication 11, caractérisé en ce qu'à l'emplacement de séparation de deux substrats individuels, on aménage au moins un trou métallisé (17) ou un trou allongé pour la métallisation des bords et en tant que point de rupture imposée.

13. Procédé selon la revendication 11, caractérisé en ce qu'on dépose les couples de surfaces de contact sur une surface du substrat, qu'on dépose un couple de surfaces de brasage sur la face opposée et qu'on établit un contact traversant entre les surfaces de contact et les surfaces de brasage réciproquement associées.

14. Procédé selon la revendication 11, caractérisé en ce qu'on équipe une bande de substrat de couples juxtaposés de surfaces de contact et qu'on métallise les bords longitudinaux en établissant une liaison électriquement conductrice avec les surfaces de contact avant de coller le conducteur fusible.

15. Procédé selon l'une des revendications 7 à 14, caractérisé en ce qu'on recouvre chaque conducteur fusible par une enveloppe en matière plastique que l'on soude thermiquement directement au substrat.

16. Procédé selon l'une des revendications 12 à 15, caractérisé en ce qu'on dépose les enveloppes en matière plastique de manière qu'elles adhèrent entre elles, en un nombre correspondant au nombre des substrats individuels et avec la même configuration et qu'on les divise ensuite lors de la division conduisant aux substrats individuels.
